# EUROPEAN PATENT APPLICATION

(11) **EP 4 629 769 A1**
(43) Date of publication of application: **08.10.2025**
(21) Application number: 24168174.1
(22) Date of filing: 03.04.2024
(51) Int. Cl.: H10B 12/00, H10B 53/20, H10B 53/30

(54) **MEMORY CELL STRUCTURES AND METHODS OF FABRICATION**

(71) Applicant: Huawei Technologies Co., Ltd., Shenzhen, Guangdong 518129 (CN)
(72) Inventor: Jin, Ming, 80992 Munich (DE); Sang, Xia, 80992 Munich (DE); Li, Wei, 80992 Munich (DE); Leonelli, Daniele, 80992 Munich (DE); Xu, Jeffrey Junhao, 80992 Munich (DE)
(74) Representative: Körber, Martin Hans

(57) **Abstract**

Memory cell structures and methods for fabrication thereof are provided, the memory cell structures include a first and second channel-all-around transistors disposed vertically relative to one another, and at least one capacitor disposed vertically in between and serially interconnecting the first and second channel-all-around transistors.

## Description

### BACKGROUND

Some embodiments described in the present disclosure relate to memory devices and technology and, more specifically, but not exclusively, to memory cell structures and methods of fabrication.

The electronics industry is under constant pressure to both reduce component size as well as power requirements and has a market driven need to improve operation and performance of memory devices. One approach to reduce component size is to fabricate devices in a three-dimensional (3D) configuration. Use of 3D technology enables higher density for the memory array core of a memory device with memory cells arranged vertically. For example, a memory device, such as a dynamic random access memory (DRAM), can be arranged as a stack of memory cells vertically on a substrate. In addition, new materials including semiconductor materials (e.g., indium gallium zinc oxide (IGZO) and/or the like), ferroelectric materials (e.g., hafnium oxide(HfO2), zirconium oxide(ZrO), and/or the like) have great potential to be introduced into industry with revolutionary scheme for high-density memory products.

### SUMMARY

It is an object of the present disclosure to describe memory cell structures and methods of fabrication.

The foregoing and other objects are achieved by the features of the independent claims. Further implementation forms are apparent from the dependent claims, the description and the figures.

According to an aspect of some embodiments of the disclosed subject matter there is provided a memory cell comprising:
a first and second channel-all-around transistors disposed vertically relative to one another; and at least one capacitor disposed vertically in between and serially interconnecting the first and second channel-all-around transistors.

Optionally, the first channel-all-around transistor is a read transistor located at bottom of the memory cell, and the second channel-all-around transistor is a write transistor located at top of the memory cell.

Optionally, the at least one capacitor is made of a ferroelectric material.

More optionally, the ferroelectric material is selected from a group consisting of: hafnium zirconium oxide, HZO; hafnium oxide, HfO2; zirconium dioxide, ZrO2; lead zirconate titanate, PZT; and aluminium scandium nitride, AlScN.

Optionally, the at least one capacitor is a single capacitor made of a high-k dielectric material.

More optionally, the high-k dielectric material is selected from a group consisting of: zirconium dioxide, ZrO2; aluminium oxide, Al2O3; lanthanum oxide, La2O3; yttrium oxide, Y2O3; silicon nitride, Si3N4; gadolinium(III) oxide, Gd2O3; tantalum pentoxide, Ta2O5; niobium pentoxide, Nb2O5; titanium dioxide, TiO2; strontium titanate, SrTiO3; hafnium oxide, HfO2; and silicon dioxide, SiO2.

According to another aspect of some embodiments of the disclosed subject matter there is provided a memory structure comprising a plurality of memory cells, each comprising: a first and second channel-all-around transistors disposed vertically relative to one another; and at least one capacitor disposed vertically in between and serially interconnecting the first and second channel-all-around transistors, the plurality of memory cells are stacked vertically on top of one another into a three-dimensional integrated stack array.

According to yet another aspect of some embodiments of the disclosed subject matter there is provided a memory structure comprising a plurality of memory cells, each comprising: a first and second channel-all-around transistors disposed vertically relative to one another; and at least one capacitor disposed vertically in between and serially interconnecting the first and second channel-all-around transistors, the plurality of memory cells are divided among and arranged into a plurality of cell arrays stacked vertically on top of one another into a three-dimensional integrated stack array.

Optionally, memory cells in each of the plurality of cell arrays are arranged into a two-dimensional grid.

According to yet another aspect of some embodiments of the disclosed subject matter there is provided a method for fabrication of at least one memory cell, comprising performing for each of the at least one memory cell: forming source and drain metals for a read transistor comprising a first metal enclosed by respective first top, bottom, and laterally surrounding layers of oxide, and a second metal over and above the first top layer of oxide; forming a first cavity for the read transistor extending from top of the second metal to an inner portion of the first metal at a vertical height within the first surrounding layer of oxide; forming the read transistor comprising providing a first gate metal extending downwardly from top of the first cavity to a vertical height within the first metal, a first intermediate enclosure of oxide surrounding an outer sidewall and bottom surfaces of the first gate metal, and a first outer enclosure of channel material surrounding an outer sidewall and bottom surfaces of the first intermediate enclosure of oxide and enclosed by an inner sidewall and bottom surfaces of the first cavity; forming a capacitor stack for at least one capacitor comprising at least one metal layer and a bottommost, topmost and zero or more intermediate layers of oxide vertically below, above and alternating with the at least one metal layer; forming a capacitor hole extending downwardly through the capacitor stack and stopped at top of the first gate metal; forming the at least one capacitor comprising providing a sidewall of a high-k dielectric material, enclosed by an inner sidewall of the capacitor hole, and surrounding a first via metal extending downwardly and through the capacitor stack; forming source and drain metals for a write transistor comprising a third metal enclosed by respective second top, bottom, and laterally surrounding layers of oxide, and a fourth metal over and above the second top layer of oxide; forming a second cavity for the write transistor extending from top of the fourth metal to an inner portion of the third metal at a vertical height within the second surrounding layer of oxide; forming the write transistor comprising providing a second gate metal extending downwardly from top of the second cavity to a vertical height within the third metal, a second intermediate enclosure of oxide surrounding an outer sidewall and bottom surfaces of the second gate metal, and a second outer enclosure of channel material surrounding an outer sidewall and bottom surfaces of the second intermediate enclosure of oxide and enclosed by an inner sidewall and bottom surfaces of the second cavity; and forming a write word line comprising a fifth metal laterally surrounded by oxide and a second via metal vertically between the fifth metal and the second gate metal, laterally surrounded by oxide.

Optionally, the at least one memory cell comprising a plurality of memory cells forming a cell array.

Optionally, the plurality of memory cells forming the cell array are arranged into a two-dimensional grid.

Optionally, the plurality of memory cells in the cell array are fabricated simultaneously.

According to yet another aspect of some embodiments of the disclosed subject matter there is provided a method for fabrication of a memory structure, comprising: obtaining a plurality of memory cells by repeatedly performing a method for fabrication of at least one memory cell, and stacking the plurality of memory cells on top of one another into a three-dimensional integrated stack array, the method for fabrication of the at least one memory cell comprising performing for each of the at least one memory cell: forming source and drain metals for a read transistor comprising a first metal enclosed by respective first top, bottom, and laterally surrounding layers of oxide, and a second metal over and above the first top layer of oxide; forming a first cavity for the read transistor extending from top of the second metal to an inner portion of the first metal at a vertical height within the first surrounding layer of oxide; forming the read transistor comprising providing a first gate metal extending downwardly from top of the first cavity to a vertical height within the first metal, a first intermediate enclosure of oxide surrounding an outer sidewall and bottom surfaces of the first gate metal, and a first outer enclosure of channel material surrounding an outer sidewall and bottom surfaces of the first intermediate enclosure of oxide and enclosed by an inner sidewall and bottom surfaces of the first cavity; forming a capacitor stack for at least one capacitor comprising at least one metal layer and a bottommost, topmost and zero or more intermediate layers of oxide vertically below, above and alternating with the at least one metal layer; forming a capacitor hole extending downwardly through the capacitor stack and stopped at top of the first gate metal; forming the at least one capacitor comprising providing a sidewall of a high-k dielectric material, enclosed by an inner sidewall of the capacitor hole, and surrounding a first via metal extending downwardly and through the capacitor stack; forming source and drain metals for a write transistor comprising a third metal enclosed by respective second top, bottom, and laterally surrounding layers of oxide, and a fourth metal over and above the second top layer of oxide; forming a second cavity for the write transistor extending from top of the fourth metal to an inner portion of the third metal at a vertical height within the second surrounding layer of oxide; forming the write transistor comprising providing a second gate metal extending downwardly from top of the second cavity to a vertical height within the third metal, a second intermediate enclosure of oxide surrounding an outer sidewall and bottom surfaces of the second gate metal, and a second outer enclosure of channel material surrounding an outer sidewall and bottom surfaces of the second intermediate enclosure of oxide and enclosed by an inner sidewall and bottom surfaces of the second cavity; and forming a write word line comprising a fifth metal laterally surrounded by oxide and a second via metal vertically between the fifth metal and the second gate metal, laterally surrounded by oxide.

According to yet another aspect of some embodiments of the disclosed subject matter there is provided a method for fabrication of a memory structure, comprising: obtaining a plurality of cell arrays of multiple memory cells by repeatedly performing for a plurality of times, and over an arrangement of a cell array each comprising a plurality of memory cells, a method for fabrication of at least one memory cell, and stacking the plurality of cell arrays on top of one another into a three-dimensional integrated stack array, the method for fabrication of the at least one memory cell comprising performing for each of the at least one memory cell: forming source and drain metals for a read transistor comprising a first metal enclosed by respective first top, bottom, and laterally surrounding layers of oxide, and a second metal over and above the first top layer of oxide; forming a first cavity for the read transistor extending from top of the second metal to an inner portion of the first metal at a vertical height within the first surrounding layer of oxide; forming the read transistor comprising providing a first gate metal extending downwardly from top of the first cavity to a vertical height within the first metal, a first intermediate enclosure of oxide surrounding an outer sidewall and bottom surfaces of the first gate metal, and a first outer enclosure of channel material surrounding an outer sidewall and bottom surfaces of the first intermediate enclosure of oxide and enclosed by an inner sidewall and bottom surfaces of the first cavity; forming a capacitor stack for at least one capacitor comprising at least one metal layer and a bottommost, topmost and zero or more intermediate layers of oxide vertically below, above and alternating with the at least one metal layer; forming a capacitor hole extending downwardly through the capacitor stack and stopped at top of the first gate metal; forming the at least one capacitor comprising providing a sidewall of a high-k dielectric material, enclosed by an inner sidewall of the capacitor hole, and surrounding a first via metal extending downwardly and through the capacitor stack; forming source and drain metals for a write transistor comprising a third metal enclosed by respective second top, bottom, and laterally surrounding layers of oxide, and a fourth metal over and above the second top layer of oxide; forming a second cavity for the write transistor extending from top of the fourth metal to an inner portion of the third metal at a vertical height within the second surrounding layer of oxide; forming the write transistor comprising providing a second gate metal extending downwardly from top of the second cavity to a vertical height within the third metal, a second intermediate enclosure of oxide surrounding an outer sidewall and bottom surfaces of the second gate metal, and a second outer enclosure of channel material surrounding an outer sidewall and bottom surfaces of the second intermediate enclosure of oxide and enclosed by an inner sidewall and bottom surfaces of the second cavity; and forming a write word line comprising a fifth metal laterally surrounded by oxide and a second via metal vertically between the fifth metal and the second gate metal, laterally surrounded by oxide.

Other systems, methods, features, and advantages of the present disclosure will be or become apparent to one with skill in the art upon examination of the following drawings and detailed description. It is intended that all such additional systems, methods, features, and advantages be included within this description, be within the scope of the present disclosure, and be protected by the accompanying claims.

Unless otherwise defined, all technical and/or scientific terms used herein have the same meaning as commonly understood by one of ordinary skill in the art to which embodiments. Although methods and materials similar or equivalent to those described herein can be used in the practice or testing of embodiments, exemplary methods and/or materials are described below. In case of conflict, the patent specification, including definitions, will control. In addition, the materials, methods, and examples are illustrative only and are not intended to be necessarily limiting.

### BRIEF DESCRIPTION OF THE SEVERAL VIEWS OF THE DRAWING(S)

Some embodiments are herein described, by way of example only, with reference to the accompanying drawings. With specific reference now to the drawings in detail, it is stressed that the particulars shown are by way of example and for purposes of illustrative discussion of embodiments. In this regard, the description taken with the drawings makes apparent to those skilled in the art how embodiments may be practiced.

In the drawings:
FIG. 1 is a schematic illustration of an exemplary memory cell structure having two channel-all-around type transistors and one capacitor (2T1C), according to some embodiments;
FIG. 2 is a schematic illustration of a cross-section of an exemplary memory cell structure having two channel-all-around type transistors and one capacitor (2T1C) at different steps of an exemplary fabrication process, according to some embodiments;
FIG. 3 is a schematic illustration of a top view of an exemplary two-dimensional (2D) grid array in which each member unit is a memory cell structure having two channel-all-around type transistors and one capacitor (2T1C) at different steps of an exemplary fabrication process, according to some embodiments;
FIG. 4 is a schematic illustration of an exemplary memory cell structure having two channel-all-around type transistors and n ferroelectric capacitors (2TnC), according to some embodiments;
FIG. 5 is a schematic illustration of a cross-section of an exemplary memory cell structure having two channel-all-around type transistors and n ferroelectric capacitors (2TnC) at different steps of an exemplary fabrication process according to some embodiments;
FIG. 6 is a schematic illustration of a top view of an exemplary two-dimensional (2D) grid array in which each member unit is a memory cell structure having two channel-all-around type transistors and n ferroelectric capacitors (2TnC) at different steps of an exemplary fabrication process, according to some embodiments; and
FIG. 7 is a schematic illustration of a cross-section of an exemplary three-dimensional (3D) integration into a stack array of M-times repetitions of a memory cell structure having two channel-all-around type transistors and n ferroelectric capacitors (2TnC), according to some embodiments.

### DETAILED DESCRIPTION

Some embodiments described in the present disclosure relate to memory devices and technology and, more specifically, but not exclusively, to memory cell structures and methods of fabrication.

The scaling of dynamic random access memory (DRAM) is of paramount importance. In recent works, two-dimensional (2D) scaling of DRAM technology has been transitioning into the extreme ultraviolet lithography (EUV) stage. However, beyond 10 nanometers (nm) node, 2D scaling necessitates high numerical aperture EUV (h-NA EUV) which poses significant challenges. In orderto achieve high density DRAM in subsequent endeavours further ahead, three-dimensional (3D) integration emerges as the key development direction for the next generation. Furthermore, the cell structure required for achieving 3D integration in DRAM remains undetermined and invites further exploration.

Embedded dynamic random access memory (eDRAM) is an important technology to break through the memory wall. Pre-existing 2D capacitor technology is difficult to be integrated as embedded memory due to the large physical size and manufacturing process incompatibility. 3D DRAM technology provides a promising solution to realize high-density eDRAM. In addition, there is a strong demand for low latency eDRAM technology in the high-performance compute-in-memory scenario. Applicable and affordable 3D-stacked eDRAM requires special design on the memory cell and fabrication process. One pre-existing structure is the 2T0C (two transistors zero capacitor) memory cell. Indium gallium zinc oxide (IGZO) is used as transistor channel material. IGZO has the advantages of low annealing temperature and large band gap. The transistor type used is designed as channel-all-around (CAA) type. The storage node (SN) is set between the write transistor (Tw) and read transistor (Tr).

Another pre-existing structure is the 2TnC or 2TnFeCAP (two transistors and two or more ferroelectric capacitors) memory cell. Using gate-all-around (GAA) type transistor as write transistor (Tw) and channel-surrounded type transistor as read transistor (Tr). Additional select transistor is required for memory cell function. Here, the two or more ferroelectric capacitors (nFeCAPs) are implemented for storage node (SN).

Yet another pre-existing structure is the horizontal 1T1C (one transistor one capacitor) 3D DRAM. Silicon or silicon germanium (Si/SiGe) epitaxial stack is used for 3D integration. Silicon is used as transistor channel material.

Such pre-existing structures suffer from many disadvantages and shortcomings.

As for the 2T0C structure, there are retention issues involved with its usage. The electrons stored in the storage node (SN) easily leak through the channel and gate of the transistors. Further, the 2T0C structure is limited in the sense that every 2T0C cell can only store 1-bit information, and the density is low. Additional stacked layers of 2T0C cell will require multiple masks, of which the cost is high.

As for the 2TnFeCAP structure, most researches focus on the architecture itself, and the physical implementation solution is not clear. Specifically, the physical design of write transistor (Tw) and read transistor (Tr) are not well defined (in some published papers, preliminary schematic showing gate-all-around for Tw, and channel-all-around for Tr) requiring separate development processes, which may dramatically increase the cost and duration of both the research and development as well as the fabrication processes involved. Select transistor is also required, thus also leading to an increased complexity. Moreover, these schemes require a very complex routing design to enable the signal input/output (I/O).

As for the horizontal 1T1C structure, the enhancement of density is limited by the stacked layers. At least 100 layers are required to achieve the density of commercially available 2D DRAM memory cells. Process for epi-stack is quite complex and expensive and of low throughput.

The disclosed subject matter is aimed at providing for memory cell structures and fabrication methods thereof that overcome shortcomings of and improve upon pre-existing memory cell structures and fabrication methods.

In some embodiments, a memory cell structure is provided having two channel-all-around (CAA) transistors and one or more capacitors there-in-between, i.e., with general form of CAA+nCaps+CAA (or 2TnC in short), where n≥1.

In some embodiments, each capacitor within the memory cell (also denoted herein as Cap) can be used to store 1-bit information. By using ferroelectric material (e.g., hafnium zirconium oxide (HZO) and/or the like) for the one or more capacitors, namely, where n ferroelectric capacitors (nFeCAPs) are provided, there can be stored n-bit information.

In some embodiments, the 2TnC universal memory cell structure according to the disclosed subject matter can be stacked cell by cell to achieve higher density stacking.

The disclosed subject matter provides for a universal high-density memory cell structure for 3D DRAM or eDRAM, which could be used in various practical scenarios and/or applications such as the exemplary following ones of high bandwidth memory (HBM), DRAM (whether as standalone chip, part of multi-chip-module/integrated circuit, or otherwise), in-memory computing, and/or the like.

One technical effect of utilizing the disclosed subject matter is to provide for improved retention performance over pre-existing technology such as for example the 2T0C memory cell and/or the like, by adding a capacitor between the write transistor (Tw) and read transistor (Tr) to reduce the electron leakage.

Another technical effect of utilizing the disclosed subject matter is to provide for simplifying of the cell structure for high density Ferroelectric-based 3D DRAM, where channel all-around transistor is implemented for Tw and Tr, and select transistor is not required. Thus, 3D DRAM may be realized more easily and/or at lower cost. Further, as Tw and Tr share same processes and materials, an overall research and development cycle may be accelerated, and the cost involved may be reduced.

Yet another technical effect of utilizing the disclosed subject matter is to provide for simplifying of the routing scheme for chip-level interconnection, as both Tw and Tr using same CAA-type transistor. The routing for terminals may thus be simplified in design and fabrication due to better consistency.

Yet another technical effect of utilizing the disclosed subject matter is to provide for a universal memory cell structure susceptible for high-density integration. The density can be improved either through nFeCAPs (n>=1) or m-layer 2TnC (m>=2, n>=1) by repeating the universal cell structure.

Before explaining at least one embodiment in detail, it is to be understood that embodiments are not necessarily limited in its application to the details of construction and the arrangement of the components and/or methods set forth in the following description and/or illustrated in the drawings and/or the Examples. Implementations described herein are capable of other embodiments or of being practiced or carried out in various ways.

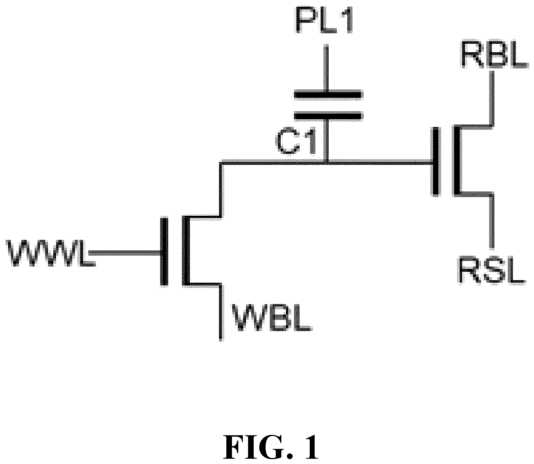

Reference is now made to FIG. 1 which is a schematic illustration of an exemplary memory cell structure having two channel-all-around type transistors and one capacitor (2T1C), according to some embodiments.

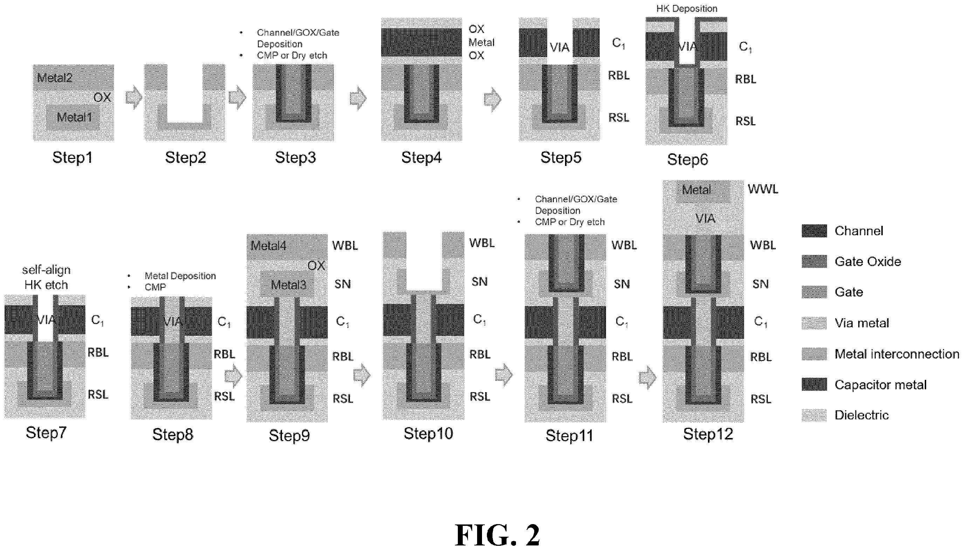

Reference is also made to FIG. 2 which is a schematic illustration of a cross-section of an exemplary memory cell structure having two channel-all-around type transistors and one capacitor (2T1C) at different steps of an exemplary fabrication process, according to some embodiments.

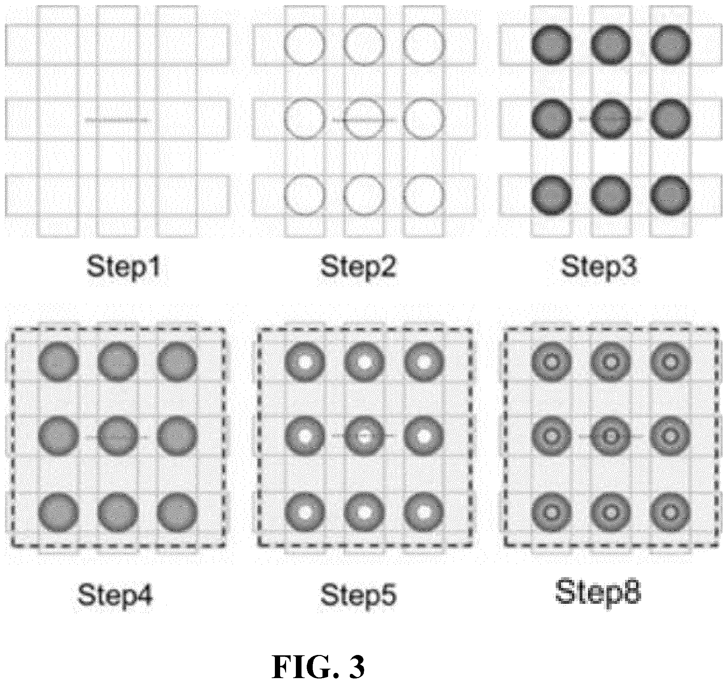

Reference is yet also made to FIG. 3 which is a schematic illustration of a top view of an exemplary two-dimensional (2D) grid array in which each member unit is a memory cell structure having two channel-all-around type transistors and one capacitor (2T1C) at different steps of an exemplary fabrication process, according to some embodiments.

For illustration purposes, FIG. 3 depicts a top view of an exemplary CAAT-C-CAAT cell array in form of a 3x3 grid, however it would be appreciated that the disclosed subject matter is not meant to be limited to any particular size and/or number of dimensions, but rather any array form, whether one dimensional (1D) or two dimensional (2D), and/or any arbitrary size in either one of the applicable dimensions, may be employed accordingly.

As shown on FIG. 1, an exemplary memory cell structure in accordance with some embodiments may be designed with two channel-all-around (CAA) type transistors, and with one capacitor (denoted as C1). The two CAA transistors may be disposed vertically of one another, and the capacitor may be placed vertically there-in-between, such that the two CAA transistors, located at bottom and top of the memory cell respectively, may be serially interconnected by the capacitor. The exemplary memory cell structure as shown on FIG. 1 may be fabricated by the exemplary fabrication process described and illustrated herein with reference to FIGs 2 and 3.

Throughout the present disclosure, the exemplary memory cell structure such as described and illustrated with reference to FIGs 1, 2, and/or 3 herein, may also be referred to interchangeably as (vertical) CAA-2T1C, CAA+C+CAA, CAAT-C-CAAT, and/or the like.

In some embodiments, the CAA transistor located at the bottom of the memory cell may be utilized as a read transistor (Tr), and the CAA transistor located at the top of the memory cell may be utilized as a write transistor (Tw). The read transistor (Tr) may include one terminal for connecting to a read transistor bit line (RBL), and another terminal for connecting to a read transistor source line (RSL), where the read transistor (Tr) may be connected at its gate to the capacitor (C1). The write transistor (Tw) may include one terminal that may be connected to the capacitor (C1), and which may form and/or otherwise provide for a storage node (SN) of the 2T1C memory cell, and another terminal for connecting to a write transistor bit line (WBL). The gate of the write transistor (Tw) may be connected to a write transistor word line (WWL). The capacitor (C1) may be connected at one end thereof to the write and read transistors (Tw and Tr), and at its other end to a capacitor plate line (denoted as PL1).

In some embodiments, the capacitor (C1) may be made of a high-k dielectric (HK) material or combination of different HK materials, such as for example, zirconium dioxide (ZrO2), aluminium oxide (Al2O3), lanthanum oxide (La2O3), yttrium oxide (Y2O3), silicon nitride (Si3N4), gadolinium(III) oxide (Gd2O3), tantalum pentoxide (Ta2O5), niobium pentoxide (Nb2O5), titanium dioxide (TiO2), strontium titanate (SrTiO3), hafnium oxide (HfO2), silicon dioxide (SiO2), and/or the like.

Additionally or alternatively, the capacitor (C1) may be made of a ferroelectric material, such as for example, hafnium zirconium oxide (HZO), hafnium oxide (HfO2), zirconium dioxide (ZrO2), lead zirconate titanate (PZT), aluminium scandium nitride (AlScN), and/or the like.

As shown in FIG. 2, an exemplary process for fabrication of a vertical CAAT-C-CAAT memory cell in accordance with some embodiments of the disclosed subject matter may include a series of steps performed sequentially and subsequently one after another to produce the cell structure in a bottoms-up incremental manner.

Further and as shown in FIG. 3, each of the steps described and illustrated with reference to FIG. 2 may be duplicated and performed individually for each of a plurality of memory cells arranged spatially in an array, optionally in parallel and/or substantially concurrent manner, so that all memory cells of the array may be thus incrementally formed and produced together practically simultaneously.

The exemplary fabrication process as shown in FIGs 2 and 3 may include a first step in which source and drain metals of a read transistor may be formed. A cross-section of the cell structure, and a top view of the cell array, as may be obtained following the first step, are illustrated in FIG. 2 and FIG. 3 respectively, and denoted therein as Step 1.

In some embodiments, the first step may begin by deposition of a first and bottommost layer of oxide (denoted as OX), followed by lithography and etching process for providing a cavity within an upper portion of the first oxide layer, where a first metal (denoted as Metal1) may be deposited thereafter.

The first metal may be, for example, titanium nitride (TiN), tungsten (W), copper (Cu), molybdenum (Mo), ruthenium (Ru), and/or the like. After deposition of the first metal, a chemical mechanical polishing (CMP) process may be employed for removing any excess material deposited.

Then, a next layer of oxide (OX) may be deposited on top of the first metal (Metal1) and of a respective portion of the first layer of oxide (OX) enclosing it. The subsequent layer of oxide (OX) deposited on top of the first metal (Metal1) and first oxide layer (OX) may similarly undergo a lithography and etching process, in preparation for deposition there-onto of a second metal (denoted as Metal2).

The second metal (Metal2) may then be deposited to cover the intermediate second layer of oxide (OX) deposited above the first metal (Metal1). The second metal (Metal2), similarly as the first metal (Metal1), may be, for example, titanium nitride (TiN), tungsten (W), copper (Cu), molybdenum (Mo), ruthenium (Ru), and/or the like. Also, and similarly as performed following deposition of the first metal (Metal1), after the second metal (Metal2) has been deposited, a CMP process may be emoployed for removal of any excess material remaining.

The exemplary fabrication process as shown in FIGs 2 and 3 may include a second step in which a hole or cavity for the read transistor may be formed. A cross-section of the cell structure and a top view of the cell array following the second step are illustrated in FIG. 2 and FIG. 3 respectively and denoted therein as Step2.

In some embodiments, at a second step of the exemplary fabrication process, a hole or cavity may be formed for the read transistor (Tr), by lithography and etching process performed on the layered combination of metal/OX/metal formed at the first step. The cavity may extend downwardly from the top of the second metal (Metal2) to an inner portion of the first metal (Metal1) and through the intermediate layer of oxide (OX) deposited in between the first and second metals.

The exemplary fabrication process as shown in FIGs 2 and 3 may include a third step in which the read transistor may be formed. A cross-section of the cell structure and a top view of the cell array following the third step are illustrated in FIG. 2 and FIG. 3 respectively and denoted therein as Step3.

In some embodiments, at a third step of the exemplary fabrication process, the read transistor (Tr) may be formed. A channel material may be deposited into the cavity formed at the second step. The channel material may be, for example, polycrystalline silicon (Poly-Si), silicon-germanium (SiGe), oxide semiconductor (OX), indium gallium zinc oxide (IGZO), and/or the like. An annealing process may be applied to the channel material deposited. The channel material may be provided by the deposition and annealing so as to cover in entirety the side walls and floor of the cavity. An oxide, high-k dielectric material (HK), and/or the like, may be deposited onto the channel material for forming a gate oxide (GOX) portion of the read transistor (Tr). The gate oxide (GOX) may be enclosed by the channel material deposited along the side walls and floor of the cavity. Then, onto the gate oxide (GOX) enclosed by the channel material, there may be deposited a metal for the gate, which may be, for example, titanium nitride (TiN), tungsten (W), copper (Cu), molybdenum (Mo), ruthenium (Ru), and/or the like. The deposition of metal for the gate may then be followed by a CMP process for removing any excesses of the dpeoisted material(s), e.g., the gate metal, gate oxide (GOX) and/or high-k dielectric material (HK), channel material, and/or the like.

In the read transistor (Tr) thus formed at the third step, a first terminal at the first metal (Metal 1) portion of the read transistor (Tr) may form of and function as a read source line (RSL) connection, and a second terminal at the second metal (Metal2) portion of the read transistor (Tr) may form of and function as a read bit line (RBL) connection, once the fabrication process of the memory cell structure has been completed.

The exemplary fabrication process as shown in FIGs 2 and 3 may include a fourth step in which a capacitor stack may be formed. A cross-section of the cell structure and a top view of the cell array following the fourth step are illustrated in FIG. 2 and FIG. 3 respectively and denoted therein as Step4.

In some embodiments, at a fourth step of the exemplary fabrication process, a bottom layer of oxide (OX) of the capacitor stack may be deposited on top of the upper portion of the read transistor (Tr) as formed at the third step, such that the aforesaid layer of oxide (OX) covers the second metal (Metal2) and the topmost portions of the gate metal, the gate oxide, and channel material of the read transistor (Tr). Then, a layer of metal for accommodating one capacitor may be deposited on top of the bottom layer of oxide (OX) of the capacitor stack. The metal may be, for example, titanium nitride (TiN), tungsten (W), copper (Cu), molybdenum (Mo), ruthenium (Ru), and/or the like. Finally, a top layer of oxide (OX) of the capacitor stack may be deposited on top of the metal layer.

The exemplary fabrication process as shown in FIGs 2 and 3 may include a fifth step in which a capacitor hole for housing the capacitor (C1) may be formed. A cross-section of the cell structure and a top view of the cell array following the fifth step are illustrated in FIG. 2 and FIG. 3 respectively and denoted therein as StepS.

In some embodiments, at a fifth step of the exemplary fabrication process, there may be formed a hole or a cavity for receiving and accommodating there-into the capacitor (C1). The hole or cavity may start from top of the upper layer of oxide (OX) of the capacitor stack formed at the fourth step and extend downwardly until the top of the read transistor (Tr). The hole or cavity may be provided by applying a lithography and etching process, stopping at the gate metal of the read transistor (Tr). The hole or cavity may be designed to receive and contain therein a metal via (VIA) between the gate metal of the read transistor (Tr) and the uppermost portion of the top layer of oxide (OX) of the capacitor stack.

The exemplary fabrication process as shown in FIG. 2 may include a sixth step in which a high-k dielectric material for forming the capacitor (C1) may be deposited. A cross-section of the cell structure following the sixth step is illustrated in FIG. 2 and denoted therein as Step6.

In some embodiments, at a sixth step of the exemplary fabrication process, a high-k dielectric material (HK) may be deposited into the capacitor hole formed at the fifth step. The deposited high-k dielectric material (HK) may be enclosed by the side walls and floor of the capacitor hole. The deposited high-k dielectric material (HK) may be formed in close proximity with an outline of the hole or cavity for receiving there-into a metal via (VIA) between the gate metal of the read transistor (Tr) and the uppermost portion of the top layer of oxide (OX) of the capacitor stack.

The high-k dielectric material (HK) for the capacitor (C1) may be, for example, zirconium dioxide (ZrO2), aluminium oxide (Al2O3), lanthanum oxide (La2O3), yttrium oxide (Y2O3), silicon nitride (Si3N4), gadolinium (III) oxide (Gd2O3), tantalum pentoxide (Ta2O5), niobium pentoxide (Nb2O5), titanium dioxide (TiO2), strontium titanate (SrTiO3), hafnium oxide (HfO2) silicon dioxide (SiO2), and/or the like.

Additionally or alternatively, a ferroelectric material, such as for example, hafnium zirconium oxide (HZO), hafnium oxide (HfO2), zirconium dioxide (ZrO2), lead zirconate titanate (PZT), aluminium scandium nitride (AlScN), and/or the like, may be utilized and deposited at the sixth step for forming the capacitor (C1).

The exemplary fabrication process as shown in FIG. 2 may include a seventh step in which the high-k dielectric material (HK) and/or ferroelectric material deposited for forming the capacitor may undergo a self-aligned HK etching process to remove the HK on the top surface and via bottom. A cross-section of the cell structure following the seventh step is illustrated in FIG. 2 and denoted therein as Step7.

In a seventh step of the exemplary fabrication process, the top surface and bottom portion of the deposited high-k dielectric material (HK) may be removed, while the remaining portion thereof on the inner side wall of the capacitor hole may be kept. The self aligned HK top surface and via bottom removal may be performed by an etching process.

The exemplary fabrication process as shown in FIGs 2 and 3 may include an eighth step in which metal for forming the capacitor may be deposited. A cross-section of the cell structure and a top view of the cell array following the eighth step are illustrated in FIG. 2 and FIG. 3 respectively and denoted therein as Step8.

In an eighth step of the exemplary fabrication process, metal for providing a via between the gate metal of the read transistor (Tr) and the topmost portion of the capacitor stack may be deposited into the capacitor hole. The via metal (VIA) may be enclosed by the high-k dielectric material (HK) on the inner side wall of the capacitor hole. The via metal (VIA) may be, for example, titanium nitride (TiN), tungsten (W), copper (Cu), molybdenum (Mo), ruthenium (Ru), and/or the like. After metal deposition, CMP process is applied to remove the metal at the top surface.

The exemplary fabrication process as shown in FIG. 2 may include a ninth step in which source and drain metals of a write transistor may be formed. The ninth step may be performed similarly to and considered as repeating of the first step. A cross-section of the cell structure following the ninth step is illustrated in FIG. 2 and denoted therein as Step9.

In a ninth step of the exemplary fabrication process, there may be deposited a layer of oxide (OX) on top of the uppermost portion of the capacitor stack and metal via (VIA) enclosed by the high-k dielectric material (HK). The deposited layer of oxide (OX) may then undergo a lithography and etching process for providing a cavity within an upper portion of said layer of oxide (OX). A third metal (denoted as Metal3) may be deposited thereafter into the cavity.

The third metal (Metal3) may form of and function as a storage node (SN) component of the memory cell structure, once its fabrication has been completed.

The third metal may be, for example, titanium nitride (TiN), tungsten (W), copper (Cu), molybdenum (Mo), ruthenium (Ru), and/or the like. After deposition of the third metal, a chemical mechanical polishing (CMP) process may be employed for removing any excess material deposited.

Then, another layer of oxide (OX) may be deposited on top of the third metal (Metal3) and of a respective portion of the previous layer of oxide (OX) enclosing it. The subsequent layer of oxide (OX) deposited on top of the third metal (Metal3) and previous oxide layer (OX) may similarly undergo a lithography and etching process, in preparation for deposition there-onto of a fourth metal (denoted as Metal4).

The fourth metal (Metal4) may then be deposited to cover the intermediate former layer of oxide (OX) deposited above the third metal (Metal3). The fourth metal (Metal4), similarly as the third metal (Metal3), may be, for example, titanium nitride (TiN), tungsten (W), copper (Cu), molybdenum (Mo), ruthenium (Ru), and/or the like. Also, and similarly as performed following deposition of the third metal (Metal3), after the fourth metal (Metal4) has been deposited, a CMP process may be employed for removal of any excess material remaining.

The exemplary fabrication process as shown in FIG. 2 may include a tenth step in which a hole or cavity for the write transistor may be formed. The tenth step may be performed similarly and considered as repeating of the second step. A cross-section of the cell structure following the tenth step is illustrated in FIG. 2 and denoted therein as Step10.

In a tenth step of the exemplary fabrication process, a hole or cavity may be formed for the write transistor (Tw), by lithography and etching process performed on the layered combination of metal/OX/metal formed at the ninth step. The cavity may extend downwardly from the top of the fourth metal (Metal4) to an inner portion of the third metal (Metal3) and through the intermediate layer of oxide (OX) deposited in between the third and fourth metals.

The exemplary fabrication process as shown in FIG. 2 may include an eleventh step in which the write transistor may be formed. The eleventh step may be performed similarly and considered as repeating of the third step. A cross-section of the cell structure following the eleventh step is illustrated in FIG. 2 and denoted therein as Step11.

In an eleventh step of the exemplary fabrication process, the write transistor (Tw) may be formed. A channel material may be deposited into the cavity formed at the tenth step. The channel material may be, for example, polycrystalline silicon (Poly-Si), silicon-germanium (SiGe), oxide semiconductor (OX), indium gallium zinc oxide (IGZO), and/or the like. An annealing process may be applied to the channel material deposited. The channel material may be provided by the deposition and annealing so as to cover in entirety the side walls and floor of the cavity. An oxide, high-k dielectric material (HK), and/or the like, may then be deposited onto the channel material for forming a gate oxide (GOX) portion of the write transistor (Tw). The gate oxide (GOX) may be enclosed by the channel material deposited along the side walls and floor of the cavity. Then, onto the gate oxide (GOX) enclosed by the channel material, there may be deposited a metal for the gate, which may be, for example, titanium nitride (TiN), tungsten (W), copper (Cu), molybdenum (Mo), ruthenium (Ru), and/or the like. The deposition of the metal for the gate may then be followed by a CMP process for removing any excesses of the deposited material(s), e.g., the gate metal, gate oxide (GOX) and/or high-k dielectric material (HK), channel material, and/or the like.

In the write transistor (Tw) thus formed at the eleventh step, a first terminal at the third metal (Metal3) portion of the write transistor (Tw) may form of and function as a storage node (SN) and may be connected to the capacitor (C1), and a second terminal at the fourth metal (Metal4) portion of the write transistor (Tw) may form of and function as a write bit line (WBL) connection, once the fabrication process of the memory cell structure has been completed.

The exemplary fabrication process as shown in FIG. 2 may include a twelfth step in which a metal and via for providing a connection to the gate of the write transistor may be formed. A cross-section of the cell structure following the twelfth step is illustrated in FIG. 2 and denoted therein as Step12.

In a twelfth step of the exemplary fabrication process, there may deposited an oxide (OX) on top of the uppermost portion of the write transistor (Tw) where the fourth metal (Metal4) and the gate of the write transistor (Tw) are at. A hole or cavity for receiving and accommodating a via material (VIA) may be formed in the oxide (OX) by a lithography and etching process. A metal for forming the via (VIA) may then be deposition into the cavity. The via metal may be, for example, titanium nitride (TiN), tungsten (W), copper (Cu), molybdenum (Mo), ruthenium (Ru), and/or the like. The via metal deposition may be followed by a CMP process for removing any excess material. An additional oxide (OX) may be then deposited on top of the formerly deposited oxide (OX) and via metal (VIA). The additional oxide (OX) may then undergo a lithography and etching process for forming therein a hole or cavity for receiving and accommodating a metal (Metal) connected at its bottom portion to the via metal (VIA). The deposited metal (Metal) at top of the memory cell structure thus obtained may form of and function as a write word line (WWL) connection.

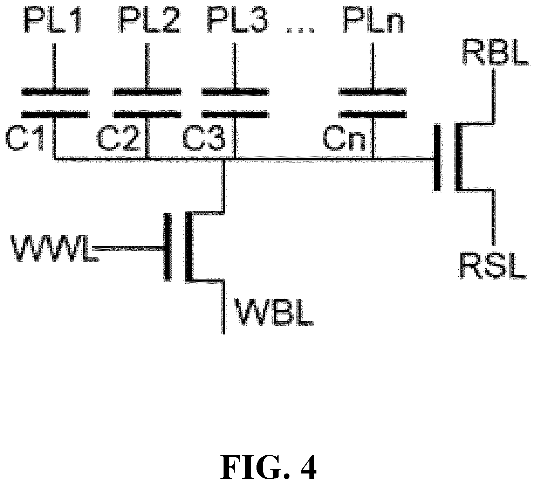

Reference is now made to FIG. 4 which is a schematic illustration of an exemplary memory cell structure having two channel-all-around type transistors and n ferroelectric capacitors (2TnC), according to some embodiments.

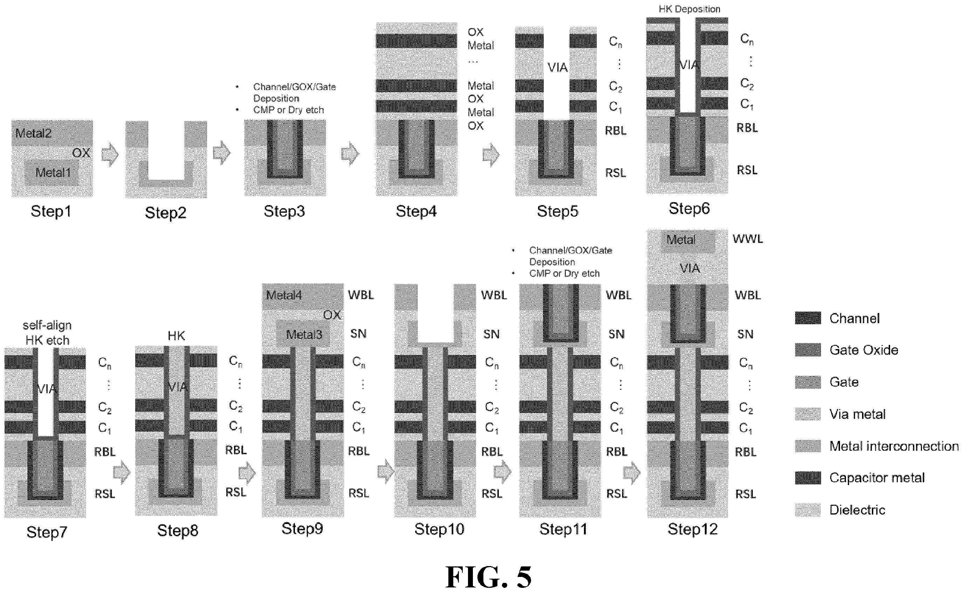

Reference is also made to FIG. 5 which is a schematic illustration of a cross-section of an exemplary memory cell structure having two channel-all-around type transistors and n ferroelectric capacitors (2TnC) at different steps of an exemplary fabrication process, according to some embodiments.

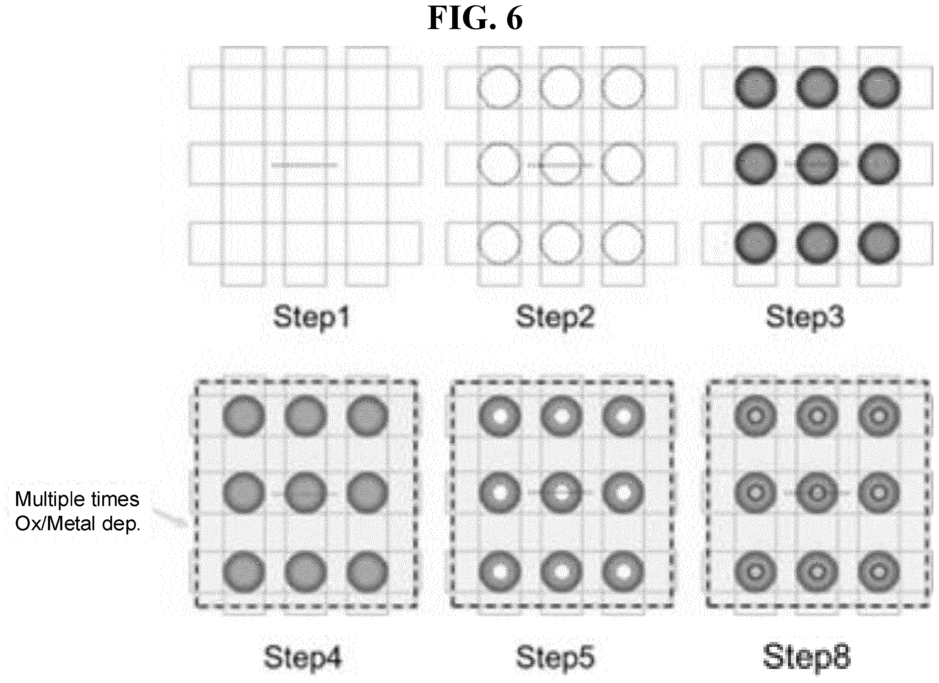

Reference is yet also made to FIG. 6 which is a schematic illustration of a top view of an exemplary two-dimensional (2D) grid array in which each member unit is a memory cell structure having two channel-all-around type transistors and n ferroelectric capacitors (2TnC) at different steps of an exemplary fabrication process, according to some embodiments.

As shown on FIG. 4, an exemplary memory cell structure in accordance with some embodiments may be designed with two channel-all-around (CAA) type transistors, and with a plurality of capacitors (denoted as C1, C2, C3, ... and Cn). The plurality of capacitors may be connected parallelly to one another. The two CAA transistors may be disposed vertically of one another, and the plurality of capacitors may be placed vertically there-in-between, such that the two CAA transistors, located at bottom and top of the memory cell respectively, may be serially interconnected by each of the plurality of capacitors. The exemplary memory cell structure as shown on FIG. 4 may be fabricated by the exemplary fabrication process described and illustrated herein with reference to FIGs 5 and 6.

Throughout the present disclosure, the exemplary memory cell structure such as described and illustrated with reference to FIGs 4, 5, and/or 6 herein, may also be referred to interchangeably as (vertical) CAA-2TnC, CAA+nC+CAA, CAAT-nC-CAAT, and/or the like.

In some embodiments, the CAA transistor located at the bottom of the memory cell may be utilized as a read transistor (Tr), and the CAA transistor located at the top of the memory cell may be utilized as a write transistor (Tw). The read transistor (Tr) may include one terminal for connecting to a read transistor bit line (RBL), and another terminal for connecting to a read transistor source line (RSL), where the read transistor (Tr) may be connected at its gate to the n-th capacitor (Cn). The write transistor (Tw) may include one terminal that may be connected to the first capacitor (C1), and which may form and/or otherwise provide for a storage node (SN) of the 2TnC memory cell, and another terminal for connecting to a write transistor bit line (WBL). The gate of the write transistor (Tw) may be connected to a write transistor word line (WWL). Each of the plurality of capacitors (C1, C2, C3, ... and Cn) may be connected at one end of each respective one of the capacitors to the write and read transistors (Tw and Tr), and at the other end of each respective one of the capacitors to a respective one of a plurality of capacitor plate lines (denoted as PL1, PL2, PL3, ... PLn).

In some embodiments, the plurality of capacitors (C1, C2, C3, ... and Cn) may be made of a ferroelectric material, such as for example, hafnium zirconium oxide (HZO), hafnium oxide (HfO2), zirconium dioxide (ZrO2), lead zirconate titanate (PZT), aluminium scandium nitride (AlScN), and/or the like.

As shown in FIG. 5, an exemplary process for fabrication of a vertical CAAT-nC-CAAT memory cell in accordance with some embodiments of the disclosed subject matter may include a series of steps performed sequentially and subsequently one after another to produce the cell structure in a bottoms-up incremental manner.

Further and as shown in FIG. 6, each of the steps described and illustrated with reference to FIG. 5 may be duplicated and performed individually for each of a plurality of memory cells arranged spatially in an array, optionally in parallel and/or substantially concurrent manner, so that all memory cells of the array may be thus incrementally formed and produced together practically simultaneously.

The exemplary fabrication process as shown in FIGs 5 and 6 may include a first step in which source and drain metals of a read transistor may be formed. A cross-section of the cell structure, and a top view of the cell array, as may be obtained following the first step, are illustrated in FIG. 5 and FIG. 6 respectively, and denoted therein as Step1.

The first step may be performed similarly to Step1 as described and illustrated with reference to FIGs 2 and 3, and thus for brevity a detailed discussion of which is merely incorporated herein by reference and not repeated verbatim herewith.

The exemplary fabrication process as shown in FIGs 5 and 6 may include a second step in which a hole or cavity for the read transistor may be formed. A cross-section of the cell structure and a top view of the cell array following the second step are illustrated in FIG. 5 and FIG. 6 respectively and denoted therein as Step2.

Further, the exemplary fabrication process as shown in FIGs 5 and 6 may include a third step in which the read transistor may be formed. A cross-section of the cell structure and a top view of the cell array following the third step are illustrated in FIG. 5 and FIG. 6 respectively and denoted therein as Step3.

Similarly as with the first step, the second and third steps may too be performed similarly to Step2 and Step3 respectively as described and illustrated with reference to FIGs 2 and 3, and thus for brevity a detailed discussion of which is merely incorporated herein by reference and not repeated verbatim herewith also.

The exemplary fabrication process as shown in FIGs 5 and 6 may include a fourth step in which a capacitor stack may be formed. A cross-section of the cell structure and a top view of the cell array following the fourth step are illustrated in FIG. 5 and FIG. 6 respectively and denoted therein as Step4.

In some embodiments, formation of the capacitor stack at the fourth step may be performed in a manner closely resembling the capacitor stack forming at Step4 as described and illustrated with reference to FIGs 2 and 3, but at a difference that the oxide and metal deposition may be repeated multiple times as a total number of capacitors to be formed, i.e., for a memory cell structure with n capacitors, the deposition of alternate layers of oxide and metal one on top of another may be repeated n times. Finally, a topmost layer of oxide may be deposited on top of the n-th layer of metal deposited.

The exemplary fabrication process as shown in FIGs 5 and 6 may include a fifth step in which a capacitor hole for housing the plurality of capacitors (C1, C2, C3, ... and Cn) may be formed. A cross-section of the cell structure and a top view of the cell array following the fifth step are illustrated in FIG. 5 and FIG. 6 respectively and denoted therein as StepS.

In some embodiments, at a fifth step of the exemplary fabrication process, there may be formed a hole or a cavity for receiving and accommodating there-into the plurality of capacitors (C1, C2, C3, ... and Cn). The hole or cavity may start from top of the upper layer of oxide (OX) of the capacitor stack formed at the fourth step and extend downwardly until the top of the read transistor (Tr). Similarly as in Step5 of FIGs 2 and 3, the hole or cavity may be provided by applying a lithography and etching process, stopping at the gate metal of the read transistor (Tr). The hole or cavity may be designed to receive and contain therein a metal via (VIA) between the gate metal of the read transistor (Tr) and the uppermost portion of the top layer of oxide (OX) of the capacitor stack.

The exemplary fabrication process as shown in FIG. 5 may include a sixth step in which a ferroelectric material for forming the plurality of capacitors (C1, C2, C3, ... and Cn) may be deposited. A cross-section of the cell structure following the sixth step is illustrated in FIG. 5 and denoted therein as Step6.

In some embodiments, at a sixth step of the exemplary fabrication process, a ferroelectric material (HK) may be deposited into the capacitor hole formed at the fifth step. The deposited ferroelectric material (HK) may be enclosed by the side walls and floor of the capacitor hole. The deposited ferroelectric material (HK) may be formed in close proximity with an outline of the hole or cavity for receiving there-into a metal via (VIA) between the gate metal of the read transistor (Tr) and the uppermost portion of the top layer of oxide (OX) of the capacitor stack.

The ferroelectric material (HK) utilized and deposited at the sixth step for forming the plurality of capacitors (C1, C2, C3, ... and Cn) may be, for example, hafnium zirconium oxide (HZO), hafnium oxide (HfO2), zirconium dioxide (ZrO2), lead zirconate titanate (PZT), aluminium scandium nitride (AlScN), and/or the like, may be.

The exemplary fabrication process as shown in FIG. 5 may include a seventh step in which the ferroelectric material deposited for forming the capacitor may undergo a self-aligned bottom etching process. A cross-section of the cell structure following the seventh step is illustrated in FIG. 5 and denoted therein as Step7.

In a seventh step of the exemplary fabrication process, the top surface and bottom portion of the deposited ferroelectric material (HK) may be removed, while the remaining portion thereof on the inner side wall of the capacitor hole may be kept. The self-aligned HK top surface and via bottom removal may be performed by an etching process.

The exemplary fabrication process as shown in FIGs 5 and 6 may include an eighth step in which metal for forming the capacitor may be deposited. A cross-section of the cell structure and a top view of the cell array following the eighth step are illustrated in FIG. 5 and FIG. 6 respectively and denoted therein as Step8.

In an eighth step of the exemplary fabrication process, metal for providing a via between the gate metal of the read transistor (Tr) and the topmost portion of the capacitor stack may be deposited into the capacitor hole. The via metal (VIA) may be enclosed by the high-k dielectric material (HK) on the inner side wall of the capacitor hole. The via metal (VIA) may be, for example, titanium nitride (TiN), tungsten (W), copper (Cu), molybdenum (Mo), ruthenium (Ru), and/or the like.

The exemplary fabrication process as shown in FIG. 5 may include a ninth step in which source and drain metals of a write transistor may be formed. The ninth step may be performed similarly to and considered as repeating of the first step. A cross-section of the cell structure following the ninth step is illustrated in FIG. 5 and denoted therein as Step9.

Further, the exemplary fabrication process as shown in FIG. 5 may include a tenth step in which a hole or cavity for the write transistor may be formed. The tenth step may be performed similarly and considered as repeating of the second step. A cross-section of the cell structure following the tenth step is illustrated in FIG. 5 and denoted therein as Step10.

Yet further, the exemplary fabrication process as shown in FIG. 5 may include an eleventh step in which the write transistor may be formed. The eleventh step may be performed similarly and considered as repeating of the third step. A cross-section of the cell structure following the eleventh step is illustrated in FIG. 5 and denoted therein as Step11.

Finally, the exemplary fabrication process as shown in FIG. 5 may include a twelfth step in which a metal and via for providing a connection to the gate of the write transistor may be formed. A cross-section of the cell structure following the twelfth step is illustrated in FIG. 5 and denoted therein as Step12.

Similarly as with the first, second and third steps of the exemplary fabrication process as shown in FIG. 5, the ninth, tenth, eleventh, and twelfth steps may too be performed similarly to Step9, Step10, Step11, and Step12 respectively as described and illustrated with reference to FIGs 2 and 3, and thus for brevity a detailed discussion of which is merely incorporated herein by reference and not repeated verbatim herewith also.

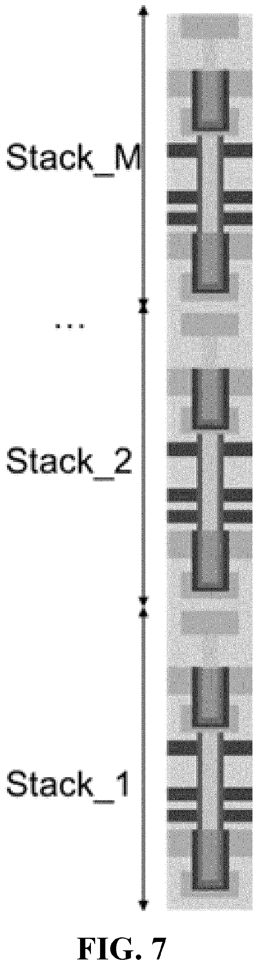

Reference is now made to FIG. 7 which is a schematic illustration of a cross-section of an exemplary three-dimensional (3D) integration into a stack array of M-times repetitions of a memory cell structure having two channel-all-around type transistors and n ferroelectric capacitors (2TnC), according to some embodiments.

As shown on FIG. 7, in some embodiments, to increase the memory density, there may be stacked vertically on top of one another a plurality of memory cells structured in accordance with the disclosed subject matter, namely, 2TnC cells with 2 CAA-type transistors and n ferroelectric capacitors (FeCAPs) for n≥1. The ferroelectric material of the capacitor may be, for example, hafnium zirconium oxide (HZO), hafnium oxide (HfO2), zirconium dioxide (ZrO2), lead zirconate titanate (PZT), aluminium scandium nitride (AlScN), and/or the like. Each capacitor may be used to store 1-bit information. By repeatedly stacking vertically on top of one another a plurality of 2TnC memory cells for M times to form a three-dimensional (3D) integrated M stack memory array, where M >=2, the total density will be greatly extended.

It will be appreciated that such 3D integration into a stack array of multiple memory cells as shown on FIG. 7 may similarly be applied also for 2T1C memory cells with 2 CAA-type transistors and one capacitor, in accordance with some embodiments of the disclosed subject matter.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

It is expected that during the life of a patent maturing from this application many relevant channel-all-around transistors and ferroelectric capacitors will be developed and the scope of the terms "transistors" and "capacitors" respectively is intended to include all such new technologies a priori.

As used herein the term "about" refers to ± 10 %.

The terms "comprises", "comprising", "includes", "including", "having" and their conjugates mean "including but not limited to". This term encompasses the terms "consisting of" and "consisting essentially of".

The phrase "consisting essentially of" means that the composition or method may include additional ingredients and/or steps, but only if the additional ingredients and/or steps do not materially alter the basic and novel characteristics of the claimed composition or method.

As used herein, the singular form "a", "an" and "the" include plural references unless the context clearly dictates otherwise. For example, the term "a compound" or "at least one compound" may include a plurality of compounds, including mixtures thereof.

The word "exemplary" is used herein to mean "serving as an example, instance or illustration". Any embodiment described as "exemplary" is not necessarily to be construed as preferred or advantageous over other embodiments and/or to exclude the incorporation of features from other embodiments.

The word "optionally" is used herein to mean "is provided in some embodiments and not provided in other embodiments". Any particular embodiment may include a plurality of "optional" features unless such features conflict.

Throughout this application, various embodiments may be presented in a range format. It should be understood that the description in range format is merely for convenience and brevity and should not be construed as an inflexible limitation on the scope of embodiments. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

Whenever a numerical range is indicated herein, it is meant to include any cited numeral (fractional or integral) within the indicated range. The phrases "ranging/ranges between" a first indicate number and a second indicate number and "ranging/ranges from" a first indicate number "to" a second indicate number are used herein interchangeably and are meant to include the first and second indicated numbers and all the fractional and integral numerals therebetween.

It is appreciated that certain features of embodiments, which are, for clarity, described in the context of separate embodiments, may also be provided in combination in a single embodiment. Conversely, various features of embodiments, which are, for brevity, described in the context of a single embodiment, may also be provided separately or in any suitable sub-combination or as suitable in any other described embodiment. Certain features described in the context of various embodiments are not to be considered essential features of those embodiments, unless the embodiment is inoperative without those elements.

Although embodiments have been described in conjunction with specific embodiments thereof, it is evident that many alternatives, modifications and variations will be apparent to those skilled in the art. Accordingly, it is intended to embrace all such alternatives, modifications and variations that fall within the spirit and broad scope of the appended claims.

It is the intent of the applicant(s) that all publications, patents and patent applications referred to in this specification are to be incorporated in their entirety by reference into the specification, as if each individual publication, patent or patent application was specifically and individually noted when referenced that it is to be incorporated herein by reference. In addition, citation or identification of any reference in this application shall not be construed as an admission that such reference is available as prior art to the present invention. To the extent that section headings are used, they should not be construed as necessarily limiting. In addition, any priority document(s) of this application is/are hereby incorporated herein by reference in its/their entirety.

## Claims

1. A memory cell comprising:
a first and second channel-all-around transistors disposed vertically relative to one another; and
at least one capacitor disposed vertically in between and serially interconnecting the first and second channel-all-around transistors.

2. The memory cell of claim 1, wherein the first channel-all-around transistor is a read transistor located at bottom of the memory cell, and the second channel-all-around transistor is a write transistor located at top of the memory cell.

3. The memory cell of claim 1, wherein the at least one capacitor is made of a ferroelectric material.

4. The memory cell of claim 3, wherein the ferroelectric material is selected from a group consisting of: hafnium zirconium oxide, HZO; hafnium oxide, HfO2; zirconium dioxide, ZrO2; lead zirconate titanate, PZT; and aluminium scandium nitride, AlScN.

5. The memory cell of claim 1, wherein the at least one capacitor is a single capacitor made of a high-k dielectric material.

6. The memory cell of claim 5, wherein the high-k dielectric material is selected from a group consisting of: zirconium dioxide, ZrO2; aluminium oxide, Al2O3; lanthanum oxide, La2O3; yttrium oxide, Y2O3; silicon nitride, Si3N4; gadolinium(III) oxide, Gd2O3; tantalum pentoxide, Ta2O5; niobium pentoxide, Nb2O5; titanium dioxide, TiO2; strontium titanate, SrTiO3; hafnium oxide, HfO2; and silicon dioxide, SiO2.

7. A memory structure comprising a plurality of memory cells, each identical to the memory cell of claim 1, stacked vertically on top of one another into a three-dimensional integrated stack array.

8. A memory structure comprising a plurality of memory cells, each identical to the memory cell of claim 1, the plurality of memory cells is divided among and arranged into a plurality of cell arrays stacked vertically on top of one another into a three-dimensional integrated stack array.

9. The memory structure of claim 8, wherein memory cells in each of the plurality of cell arrays are arranged into a two-dimensional grid.

10. A method for fabrication of at least one memory cell, comprising performing for each of the at least one memory cell:
forming source and drain metals for a read transistor comprising a first metal enclosed by respective first top, bottom, and laterally surrounding layers of oxide, and a second metal over and above the first top layer of oxide;
forming a first cavity for the read transistor extending from top of the second metal to an inner portion of the first metal at a vertical height within the first surrounding layer of oxide;
forming the read transistor comprising providing a first gate metal extending downwardly from top of the first cavity to a vertical height within the first metal, a first intermediate enclosure of oxide surrounding an outer sidewall and bottom surfaces of the first gate metal, and a first outer enclosure of channel material surrounding an outer sidewall and bottom surfaces of the first intermediate enclosure of oxide and enclosed by an inner sidewall and bottom surfaces of the first cavity;
forming a capacitor stack for at least one capacitor comprising at least one metal layer and a bottommost, topmost and zero or more intermediate layers of oxide vertically below, above and alternating with the at least one metal layer;
forming a capacitor hole extending downwardly through the capacitor stack and stopped at top of the first gate metal;
forming the at least one capacitor comprising providing a sidewall of a high-k dielectric material, enclosed by an inner sidewall of the capacitor hole, and surrounding a first via metal extending downwardly and through the capacitor stack;
forming source and drain metals for a write transistor comprising a third metal enclosed by respective second top, bottom, and laterally surrounding layers of oxide, and a fourth metal over and above the second top layer of oxide;
forming a second cavity for the write transistor extending from top of the fourth metal to an inner portion of the third metal at a vertical height within the second surrounding layer of oxide;
forming the write transistor comprising providing a second gate metal extending downwardly from top of the second cavity to a vertical height within the third metal, a second intermediate enclosure of oxide surrounding an outer sidewall and bottom surfaces of the second gate metal, and a second outer enclosure of channel material surrounding an outer sidewall and bottom surfaces of the second intermediate enclosure of oxide and enclosed by an inner sidewall and bottom surfaces of the second cavity; and
forming a write word line comprising a fifth metal laterally surrounded by oxide and a second via metal vertically between the fifth metal and the second gate metal, laterally surrounded by oxide.

11. The method of claim 10, wherein the at least one memory cell comprising a plurality of memory cells forming a cell array.

12. The method of claim 11, wherein the plurality of memory cells forming the cell array are arranged into a two-dimensional grid.

13. The method of claim 11, wherein the plurality of memory cells in the cell array are fabricated simultaneously.

14. A method of fabrication of a memory structure comprising:
repeatedly performing for a plurality of times the method of claim 10, thereby obtaining a plurality of memory cells; and
stacking the plurality of memory cells on top of one another into a three-dimensional integrated stack array.

15. A method of fabrication of a memory structure comprising:
repeatedly performing for a plurality of times, and over an arrangement of a cell array each comprising a plurality of memory cells, the method of claim 10, thereby obtaining a plurality of cell arrays of multiple memory cells; and stacking the plurality of cell arrays on top of one another into a three-dimensional integrated stack array.

## Amended claims

### Amended claims in accordance with Rule 137(2) EPC.

1. A memory cell comprising:
a first transistor and a second transistor disposed vertically relative to one another, the first transistor being a read transistor and the second transistor being a write transistor; and
at least one capacitor disposed vertically in between and serially interconnecting the first transistor and the second
transistor;
wherein the read transistor comprises:
- a source metal and a drain metal comprising a first metal enclosed by respective first top, bottom, and layers of oxide arranged laterally surrounding the first metal, and a second metal arranged over and above a first top layer of oxide;
- a first cavity arranged extending from top of a second metal to an inner portion of the first metal at a vertical height within a first surrounding layer of oxide;
- a first gate metal arranged extending downwardly from top of a first cavity to a vertical height within the first metal;
- a first intermediate enclosure of oxide arranged surrounding an outer sidewall and bottom surfaces of the first gate metal; and
- a first outer enclosure of channel material arranged surrounding an outer sidewall and bottom surfaces of the first intermediate enclosure of oxide and enclosed by an inner sidewall and bottom surfaces of the first cavity;
wherein the at least one capacitor is formed from a capacitor stack, the capacitor stack comprising:
- at least one capacitor comprising at least one metal layer and a bottommost, topmost and zero or more intermediate layers of oxide vertically below, above and alternating with the at least one metal layer;
- a capacitor hole formed extending downwardly through the capacitor stack and stopped at top of the first gate metal;
- the at least one capacitor further comprising a sidewall of a high-k dielectric material enclosed by an inner sidewall of the capacitor hole, and arranged surrounding a first via metal extending downwardly and through the capacitor stack;
and
wherein the write transistor comprises:
- source and drain metals comprising a third metal enclosed by respective second top, bottom, and laterally surrounding layers of oxide, and a fourth metal over and above the second top layer of oxide;
- a second cavity formed extending from top of the fourth metal to an inner portion of the third metal at a vertical height within the second surrounding layer of oxide;
- a second gate metal that extend downwardly from top of the second cavity to a vertical height within the third metal,
- a second intermediate enclosure of oxide surrounding an outer sidewall and bottom surfaces of the second gate metal, and a second outer enclosure of channel material surrounding an outer sidewall and bottom surfaces of the second intermediate enclosure of oxide and enclosed by an inner sidewall and bottom surfaces of the second cavity; and
- a write word line comprising a fifth metal laterally surrounded by oxide and a second via metal vertically between the fifth metal and the second gate metal, laterally surrounded by oxide.

2. The memory cell of claim 1, wherein the first transistor and the second transistor are channel-all-around transistors, the first transistor is located at the bottom of the memory cell, and the second transistor is located at the top of the memory cell.

3. The memory cell of claim 1, wherein the at least one capacitor is made of a ferroelectric material.

4. The memory cell of claim 3, wherein the ferroelectric material is selected from a group consisting of: hafnium zirconium oxide, HZO; hafnium oxide, HfO2; zirconium dioxide, ZrO2; lead zirconate titanate, PZT; and aluminium scandium nitride, AlScN.

5. The memory cell of claim 1, wherein the at least one capacitor is a single capacitor made of a high-k dielectric material.

6. The memory cell of claim 5, wherein the high-k dielectric material is selected from a group consisting of: zirconium dioxide, ZrO2; aluminium oxide, Al2O3; lanthanum oxide, La2O3; yttrium oxide, Y2O3; silicon nitride, Si3N4; gadolinium(III) oxide, Gd2O3; tantalum pentoxide, Ta2O5; niobium pentoxide, Nb2O5; titanium dioxide, TiO2; strontium titanate, SrTiO3; hafnium oxide, HfO2; and silicon dioxide, SiO2.

7. A memory structure comprising a plurality of memory cells, each identical to the memory cell of claim 1, stacked vertically on top of one another into a three-dimensional integrated stack array.

8. A memory structure comprising a plurality of memory cells, each identical to the memory cell of claim 1, the plurality of memory cells is divided among and arranged into a plurality of cell arrays stacked vertically on top of one another into a three-dimensional integrated stack array.

9. The memory structure of claim 8, wherein memory cells in each of the plurality of cell arrays are arranged into a two-dimensional grid.

10. A method for fabrication of at least one memory cell, comprising performing for each of the at least one memory cell:
forming source and drain metals for a read transistor comprising a first metal enclosed by respective first top, bottom,
and laterally surrounding layers of oxide, and a second metal over and above the first top layer of oxide;
forming a first cavity for the read transistor extending from top of the second metal to an inner portion of the first metal at a vertical height within the first surrounding layer of oxide;
forming the read transistor comprising providing a first gate metal extending downwardly from top of the first cavity to a vertical height within the first metal, a first intermediate enclosure of oxide surrounding an outer sidewall and
bottom surfaces of the first gate metal, and a first outer enclosure of channel material surrounding an outer sidewall and bottom surfaces of the first intermediate enclosure of oxide and enclosed by an inner sidewall and bottom surfaces of the first cavity;
forming a capacitor stack for at least one capacitor comprising at least one metal layer and a bottommost, topmost and zero or more intermediate layers of oxide vertically below, above and alternating with the at least one metal layer;
forming a capacitor hole extending downwardly through the capacitor stack and stopped at top of the first gate metal;
forming the at least one capacitor comprising providing a sidewall of a high-k dielectric material, enclosed by an inner sidewall of the capacitor hole, and surrounding a first via metal extending downwardly and through the capacitor stack;
forming source and drain metals for a write transistor comprising a third metal enclosed by respective second top, bottom, and laterally surrounding layers of oxide, and a fourth metal over and above the second top layer of oxide;
forming a second cavity for the write transistor extending from top of the fourth metal to an inner portion of the third metal at a vertical height within the second surrounding layer of oxide;
forming the write transistor comprising providing a second gate metal extending downwardly from top of the second cavity to a vertical height within the third metal, a second intermediate enclosure of oxide surrounding an outer sidewall and bottom surfaces of the second gate metal, and a second outer enclosure of channel material surrounding an outer sidewall and bottom surfaces of the second intermediate enclosure of oxide and enclosed by an inner sidewall and
bottom surfaces of the second cavity; and
forming a write word line comprising a fifth metal laterally surrounded by oxide and a second via metal vertically between the fifth metal and the second gate metal, laterally surrounded by oxide.

11. The method of claim 10, wherein the at least one memory cell comprising a plurality of memory cells forming a cell array.

12. The method of claim 11, wherein the plurality of memory cells forming the cell array are arranged into a two-dimensional grid.

13. The method of claim 11, wherein the plurality of memory cells in the cell array are fabricated simultaneously.

14. A method of fabrication of a memory structure comprising:
repeatedly performing for a plurality of times the method of claim 10, thereby obtaining a plurality of memory cells; and
stacking the plurality of memory cells on top of one another into a three-dimensional integrated stack array.

15. A method of fabrication of a memory structure comprising:
repeatedly performing for a plurality of times, and over an arrangement of a cell array each comprising a plurality of memory cells, the method of claim 10, thereby obtaining a plurality of cell arrays of multiple memory cells; and stacking the plurality of cell arrays on top of one another into a three-dimensional integrated stack array.
